Europäisches Patentamt

European Patent Office

Office européen des brevets

(11) Publication number: 0 339 737
A1

## (12) EUROPEAN PATENT APPLICATION

(21) Application number: 89201053.9

(22) Date of filing: 24.04.89

(51) Int. Cl.⁴: H03K 19/096 , H03K 3/356

(30) Priority: 29.04.88 NL 8801119

(43) Date of publication of application:
02.11.89 Bulletin 89/44

(84) Designated Contracting States:
CH DE FR GB IT LI NL

(71) Applicant: N.V. Philips' Gloeilampenfabrieken
Groenewoudseweg 1
NL-5621 BA Eindhoven(NL)

(72) Inventor: De Loore, Bart Jozef Suzanne
c/o INT. OCTROOIBUREAU B.V.
Prof.Holstlaan 6
NL-5656 AA Eindhoven(NL)

(74) Representative: Strijland, Wilfred et al
INTERNATIONAAL OCTROOIBUREAU B.V.
Prof. Holstlaan 6
NL-5656 AA Eindhoven(NL)

(54) Integrated circuit having combinatorial logic functionality and provided with transmission gates having a low threshold voltage.

(57) Integrated logic CMOS-circuit which operates at a reduced supply voltage between 2 and 3.6 Volts. So as to provide reliable operation of the circuit at this low supply voltage and to substantially limit the power dissipation in this logic circuit it is proposed to design the transmission gates (T1,T2) in that circuit as one single N-channel transistor having a threshold voltage which is less than or equal to half the threshold voltage of NMOS-transistors in further gates of the logic CMOS-circuit. Preferably, the lower threshold voltage of NMOS-transistors in the transmission gates is approximately 0.3 Volt.

EP 0 339 737 A1

## Integrated circuit having combinatorial logic functionality and provided with transmission gates having a low threshold voltage.

### BACKGROUND TO THE INVENTION

The invention relates to an integrated circuit having combinatorial logic functionality and comprising transmission gates and sub-circuits interconnected thereto. Transmission gates can be used in an adder circuit, in an arithmetic logic unit, and in various other circuitry types such as static or dynamic memories, multiplexers, logic gates such as AND-gates, OR-gates, EXOR-gates. The provision of combinatorial logic functionality means that the integrated circuit's function is not limited to that of a memory function in isolation.

### SELECTED PRIOR ART

Circuits as recited supra have been disclosed in European Patent Application 164,450 and United States Patent 4,498,135 considering an adder and an ALU, respectively.

Developments now in progress in the field of integrating logic systems on a semiconductor substrate combine increasingly more components on an ever smaller substrate surface area. A problem then occurring is the resultant higher energy dissipation per substrate area unit. An ultimitedly increased energy dissipation would result in destruction of the integrated circuit. A measure to reduce the energy dissipation per area unit would be a reduction of the supply voltage. However, a reduction of the supply voltage cannot be effected without further measures, as, with the object of increasing the integration density, the transmission gates utilized are not designed as full CMOS-transmission gates but comprise only a single NMOS-transistor. The result thereof is that a signal supplied to one side of the transmission gate has at the other side an amplitude loss in the order of magnitude of the effective threshold voltage of this transistor. At a lower supply voltage which, for example, may lie between 2 and 3,6 Volts, as proposed by the JEDEC Standard No. 8 of the Electronic Industries Association, this lower amplitude of the signal causes a substantial increase in the static power dissipation in the integrated circuit during given logic states. In addition, it also increases the sensitivity to noise. The interference margin decreases since the voltage swing of the logic signal decreases. If the usual threshold voltages of approximately 1 Volt are allowed, these circuits would even not function at all at a supply voltage of 2 Volts.

### SUMMARY TO THE INVENTION

Among other things, it is an object of the present invention to provide an integrated circuit having combinatorial logic functionality, which circuit which has a high integration density, can operate with a high degree of reliability at a high switching frequency and in which the power dissipation, more specifically the static power dissipation, is very low.

An integrated logic circuit according to the invention is therefore characterized, in that the threshold voltage of the transistors of the transmission gates is lower than the threshold voltage of the transistors in a sub-circuit connected to the transmission gate. The use of low-threshold voltage transistors in the transmission gates will cause a lower signal loss, so that the transistors in the sub-circuit connected to the transmission gates can be driven to an improved extent. As a result thereof the sub-circuit will evidence an improved switching behaviour and will have a lower dissipation at the change from one to the other logic state.

### DISCUSSION OF SUPPLEMENTARY ART

Ancillary to the earlier citations, US Patent 4,250,406 to Alaspa describes a single-clock CMOS logic circuit with selected threshold voltages. Notably, this specification deals with a shift register having a cascaded arrangement of alternating transmission gates and inverters. The single-transistor transmission gates alternatingly have a p-MOS-transistor and an n-MOS-transistor with threshold voltages in the range 0.4-0.8 Volts. The inverters each comprise an arrangement of a p-MOS-transistor and an n-MOS-transistor with threshold voltages in the range 1.1-1.5 Volts. The object of the known circuit is to minimize the number of transistors by adjusting their threshold voltages and in particular doing so by adjusting the p-channel threshold voltage downward in preselected transistors and to adjust the n-channel threshold voltage upward in certain transistors. Another object of the known circuit is to attain reduced complexity due to the elimination of one clock line.

The present invention envisages operability of the circuit at lower supply voltages. Further, it applies to combinatory logic functionality. The only logic aspect of the reference is the handling of logic signals, not the generation of combinatory logic functions. In particular realizations of the present invention, all transfer gates consist of n-MOS-transistors only. In particular realizations of the invention, also multiple clock signals are present. In particular realizations of the present invention, various parallel input logic signals are selectively gates for logic processing. In particular realizations of the present invention only reduction of n-MOS-transistor voltage is contemplated.

## FURTHER ASPECTS OT THE INVENTION

An embodiment of a logic integrated circuit according to the invention is characterized, in that the ratio between the threshold voltage of transistors in the transmission gates and threshold voltages of transistors in other sub-circuits is approximately equal to or less than 0.6. Said measure achieves that the voltage swing at the input of a circuit gate connected to the transmission gate remains adequately large to drive part of the transistors present in the circuit gate fully to the conducting state and other transistors in that switching gate fully to the non-conducting state.

A preferred embodiment of a logic circuit according to the invention is characterized, in that the threshold voltage of the transistors in the transmission gates is approximately 0.3 Volt. When such a measure is taken, it is possible to have the logic circuit also function at a low supply voltage of, for example, 2 Volts. Only a low logic signal loss is then produced across the transmission gates. Consequently, the threshold voltages of the transistors of the sub-circuit connected to the transmission gates, the sub-circuits being provided, for example, with CMOS transistors, can be chosen relatively high, thus limiting the Off-State current of these transistors to a very significant extent.

The invention and how it can be put into effect will now be described in greater detail by way of example with reference to an example of a multiplex circuit, shown in the accompanying drawings.

## DESCRIPTION OF A PREFERRED EMBODIMENT

The multiplex circuit comprises an inverter circuit including p-MOS-transistor P1 and n-MOS-transistor N1 and two transmission gates formed by respective n-MOS-transistor T1 and T2. The inputs I1 and I2 of the multiplex circuit may receive mutually independent logic signals and are selectively connectable under the control of control signals C and C̄ to the input I of the inverter. The signals C and C̄ may be complementary signals such as complementary clock signals. These may have various relative time relationships, inter alia, such that transmissivity of either transistor T1 or T2 is terminated some time before transmissivity of the other transistor of transistors T2, T1 commences. The treshold voltages of the transistors T1 and T2 of the transmission gates are in the order of magnitude of 0.2 Volt. The spread in the threshold voltages of these transistors can then be 0.1 Volt. If the spread of these threshold voltages were 0.05 Volt, then the threshold voltage of the transistors T1 and T2 of the transmission gates might be, for example, 0.15 Volt. The threshold voltage of the PMOS-transistor P1 and the NMOS-transistor N1 in the inverter are approximately 1 Volt. By itself, adjustment of threshold voltages can be effected by standard amendment of implantation steps that are used in integrate circuit manufacturing technology. If the circuit in question gets a supply voltage $V_{DD}$ equal to 2 Volts, then this circuit will operate in a desired manner and an only very low static dissipation will occur. If the threshold voltage of the transistors T1 and T2 of the transmission gate would be 1 Volt, then the effective threshold voltage is higher because of the substrate-source voltage and with a maximum input signal of 2 Volts at an input I1 or I2 of the multiplex circuit a residual signal having an amplitude less than 1 Volt will only appear at the input I of the inverter. The foregoing implies that the PMOS-transistor P1 remains slightly conductive and the NMOS-transistor N1 will not conduct, which means that the inverter circuit is not functioning. If the threshold voltage of the transistors T1 and T2 in the transmission gates is approximately 0.3 Volt, then when a signal of 2 Volts is applied to the input of the multiplex circuit a residual signal of nearly 1.7 Volt will remain at the input of the inverter. A signal having such an amplitude provides that the NMOS-transistor N1 is in its fully conductive state and that the PMOS-transistor P1 is completely cut-off.

For the increasingly larger integrated logic circuits the data processing power is important. This implies that the highest possible number of functions are to be integrated on a single substrate so as to reduce the total costs of a complete processing system. The processing power of the logic circuitry of an integrated circuit can be expressed in terms of the properties of a basic circuit representative of logic circuits. The processing power PP is proportional to the substrate area on which the logic circuit, designed with CMOS-transistors, is accommodated, and is also proportional to the functional integration density of the circuit and is also proportional to the switching frequency thereof. Expressed in a formula: $PP = A \times D \times fs$, wherein A is the area of the substrate on which the logic circuit is integrated, D is the circuit-functional integration density and fs the switching frequency. Two main factors which limit the processing power and determine the cost aspect of an integrated logic circuit, are the substrate area and the power dissipation. The power dissipation is the sum of the dynamic and the static dissipation. If ED is the energy required for forming a logic function in a basic circuit then the power dissipation in an integrated logic circuit is equal to

P = A x D x (fs x Ed + Pstat)

wherein Pstat is the static power dissipation. Two cost indicators can be extracted from the above formulae, namely

$$\frac{A}{PP} = \frac{1}{D \times fs} \qquad (1)$$

and

$$\frac{P}{PP} = Ed + \frac{Pstat}{fs} \qquad (2)$$

The cost aspect of an integrated logic circuit can be expressed as

$$COST = \frac{A}{PP} \times \frac{P}{PP} \qquad (3)$$

When an integrated logic circuit is designed, it is not previously known whether the expression (1) or the expression (2) limits the processing power. However, the general cost aspect expressed in formula (3) is the product of the formulae (1) and (2) and all parameters in this cost aspect can be evaluated by means of simulations. If now, with the object of reducing the cost aspect, the term Ed is reduced compared with equation (2) by decreasing the supply voltage then the customary threshold voltages of 1 Volt cannot be maintained for all MOS-transistors, as the interference margin thereof is significantly reduced as is also the switching rate. The charging and discharging currents for a capacitor provided at the output of the inverter are reduced by a factor that is proportional to the square value of the now lower gate-source drive voltage, so that a smaller control signal requires a longer charging and discharging periods. In the extreme case, as in the example ($V_{DD}$ = 2 Volts, threshold voltages: 1 Volt) stated in the foregoing, the circuit will even not operate at all. A different solution would be to reduce the threshold voltages (1 Volt - 0.4 Volt) in proportion with the same scaling factor as the supply voltage (5 Volts - 2 Volts) so as to render it possible to guarantee that the logic circuit will indeed function in the desired manner. From the equation (2) it follows that this indeed reduces the cost aspect. The switching frequency indeed decreases proportionally to a scaling factor, but the dynamic dissipation Ed is quadratically proportional and consequently decreases to a greater extent. It should be noted that when this measure is used, also the noise behaviour does not deteriorate so that also from that point of view the proposed measure is acceptable. However, it has been found that this approach has disadvantages. Notably, sub-threshold leakage currents do not decrease when the dimensions of the transistor are reduced or when the supply voltage is decreased are produced in the transistors. In addition, the Off-State-current in a transistor increases exponentially with (-qVT/nKT). When the threshold voltage VT is linearly scaled with the supply voltage this exponential function causes a substantial increase in the dissipation.

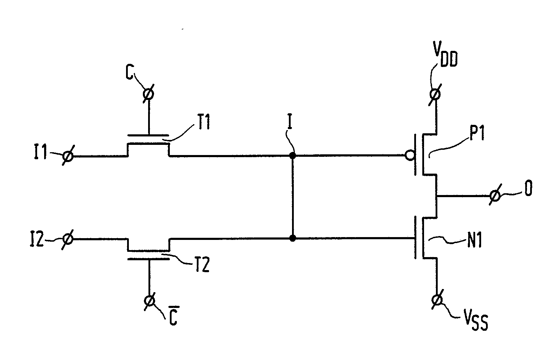

According to the invention, in an integrated logic circuit in which transmission gates having only one single N-type MOS-transistor are utilized, two different threshold voltages are used for the N-type MOS-transistors. The single N-channel transistor in the transmission gate has a lower threshold voltage than the NMOS transistor in the logic sub-circuits which are connected to the output of the transmission gate. Because of the use of the lower threshold voltage for the NMOS-transistors in a transmission gate the signal loss across the transmission gate is less, which results in an improved noise margin and noise behaviour. The contribution of the leakage currents in the transmission gates to the overall dissipation will be low in VLSI-circuits, since the principal leakage currents occur in embedded memories, in which a high amount of leakage paths are present, and in input/output buffers in which very wide transistors are used. However, in the latter logic modules CMOS-transistors having a higher threshold voltage can be used which substantially limits the power dissipation due to leakage currents and Off-State-currents. The circuit according to the Figure only is given by way of example; various other types of subcircuits may be provided either at the inputs and at the outputs of the transmission gates.

## Claims

1. An integrated cirucit having combinatorial logic functionality and provided with transmission gates and subcircuits connected thereto, characterized in that the threshold voltage of transistors of the transmission gates is lower than the threshold voltage of the transistors of a sub-circuit connected to one of the transmission gate.

2. An integrated circuit as claimed in Claim 1, wherein said transmission gates comprise a first type transmission gate and a second type transmission gate, and wherein said first and second type are controlled by mutually time-exclusive control signals.

3. An integrated circuit as claimed in Claim 2, wherein said time-exclusive control signals are complementary clock signals.

4. An integrated cirtcuit as claimed in any of Claims 1, 2 or 3, wherein said subcircuits are powered by a standard supply voltage that is substantially less than 4 Volts.

5. An integrated circuit as claimed in any of Claims 1 through 4 comprising multiple transmission gates interconnecting a set of subcircuits, wherein all said multiple transmission gates comprise exclusively n-MOS-transistors.

6. An integrated circuit as claimed in any of Claims 1 through 5, and having receiving means for receiving at least two functionally independent logic signals coincidentally at two respective inputs.

7. An integrated circuit as claimed in Claim 6, wherein said respective inputs are non-control inputs of respective transmission gates.

8. An integrated circuit as claimed in any of Claims 1 through 7, wherein at least two transmission gates have their respective outputs feed a common input of a particular further subcircuit.

9. An integrated circuit as claimed in any of Claims 1 through 8 and adhering to JEDEC Standard No. 8 of the Electronics Industry Association.

10. An integrated circuit as claimed in any of Claims 1 through 9, wherein said further subcircuit has transistors with a threshold voltage at approximately 1 Volt.

11. An integrated circuit as claimed in any of Claims 1 through 10, wherein said further subcircuit is an inverter.

12. An integrated circuit as claimed in any of Claims 1 through 11, wherein the ratio between the threshold voltage of transistors in the transmission gates and transistors in further subcircuits of the logic circuit is approximately equal to or less than 0.6.

13. An integrated circuit as claimed in any of Claims 1 through 12, wherein the threshold voltage of the transistor in the transmission gates is approximately 0.3 Volt.

14. An integrated circuit as claimed in any of Claims 1 through 13, wherein complementary transistors are used, characterized in that a transmission gate includes only one single NMOS-transistor.

European Patent
Office

**EUROPEAN SEARCH REPORT**

Application Number

EP 89 20 1053

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,D | US-A-4 250 406 (ALASPA) <br> * Column 2, line 64 - column 3, line 57; figure 2 * | 1,10-14 | H 03 K 19/096 <br> H 03 K 3/356 |
| Y | | 2,3,5-8 | |
| Y | WO-A-8 605 935 (AMERICAN TELEPHONE & TELEGRAPH CO.) <br> * Page 10, lines 9-23; figure 5 * | 2,3,5,8 | |
| Y | US-A-4 595 845 (BRIGGS) <br> * Column 1, line 44 - column 2, line 23; figure 1 * | 6,7 | |
| | | | TECHNICAL FIELDS SEARCHED (Int. Cl.4) |
| | | | H 03 K |

The present search report has been drawn up for all claims

| Place of search | Date of completion of the search | Examiner |
|---|---|---|
| THE HAGUE | 20-07-1989 | CANTARELLI R.J.H. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)